# EUROPEAN PATENT APPLICATION

(11) **EP 4 741 863 A1**
(43) Date of publication of application: **13.05.2026**
(21) Application number: 24211428.8
(22) Date of filing: 07.11.2024
(51) Int. Cl.: G01R 33/3873

(54) **FIBER OPTIC MEASUREMENT OF PASSIVE SHIM ELEMENT TEMPERATURE**

(71) Applicant: Koninklijke Philips N.V., 5656 AG Eindhoven (NL)
(72) Inventor: LIPS, Oliver, Eindhoven (NL); VOGTMEIER, Gereon, Eindhoven (NL); WEIß, Steffen, 5656AG Eindhoven (NL)
(74) Representative: Philips Intellectual Property & Standards

(57) **Abstract**

Disclosed herein is a passive shim system (100) for a magnetic resonance imaging system (400). The passive shim system comprises a mounting system (106) for mechanically receiving and positioning multiple passive shim elements (112). The passive shim system comprises multiple fiber optic temperature sensors (110) configured for optically measuring sensor specific temperature data (126). The multiple fiber optic temperature sensors are thermally coupled to the mounting system and/or the multiple passive shim elements. The passive shim system comprises a controller (114) comprising a local memory (120) and a local computational system (116). The local memory stores local machine executable instructions (124). Execution of the local machine executable instructions causes the local computational system to repeatedly: control (300) the multiple fiber optic temperature sensors to measure the sensor specific temperature data, and provide (302) the sensor specific temperature data.

## Description

### FIELD OF THE INVENTION

The invention relates to magnetic resonance imaging, in particular to the shimming of the main magnetic field.

### BACKGROUND OF THE INVENTION

Magnetic Resonance Imaging (MRI) is a medical imaging technique that uses a strong magnetic field, often referred to as the main magnetic field or the B₀ field, and Radio Frequency (RF) signals to generate detailed images which depict a subject's internal anatomy. The main magnetic field is used to align atomic spins, typically hydrogen protons in the subject. The system then uses RF pulses to manipulate these spins. During relaxation of the atomic spins, they emit radio signals which are then used to reconstruct a magnetic resonance image. The uniformity of the magnetic field affects the quality of the magnetic resonance image. This main magnetic field uniformity can be enhanced or "shimmed" using both active and passive methods. Active shimming involves the use of shimming coils that adjust the field dynamically by controlling the current through the shimming coils. Passive shimming employs strategically placed passive shim elements (i.e., small pieces of ferromagnetic materials) to fine-tune the magnetic field.

United State patent application publication US8723523B2 discloses magnetic resonance imaging apparatus includes: a pair of static magnetic field generators separately disposed at the top and bottom of an imaging space in which a subject is placed; a shim magnetic material, disposed on the imaging-space side of each of the pair of static magnetic field generators, for generating a magnetic field to adjust the static magnetic field; a gradient magnetic field generator; a high-frequency magnetic field generator; a temperature sensor for directly or indirectly measuring the temperature of the shim magnetic material; and a controller for controlling the gradient magnetic field generator and the high-frequency magnetic field generator to execute an imaging pulse sequence. The controller determines the inhomogeneity of the static magnetic field from the output of the temperature sensor, considering the change in a magnetic field adjustment parameter due to the temperature change of the shim magnetic material, and causes a warning message to be presented if the determined static magnetic field inhomogeneity has exceeded a predetermined allowable value.

### SUMMARY OF THE INVENTION

The invention provides for a passive shim system, a main magnet, a magnetic resonance imaging system, a method of using a magnetic resonance imaging system and a computer program. Embodiments are given in the dependent claims.

In one aspect a passive shim system for a magnetic resonance imaging system is disclosed. The passive shim system comprises a mounting system for mechanically receiving and positioning multiple passive shim elements. The passive shim system further comprises multiple fiber optic temperature sensors that are configured for optically measuring sensor-specific temperature data. The multiple fiber optic temperature sensors are thermally coupled to the mounting system and/or the multiple passive shim elements. The passive shim system further comprises a controller comprising a local memory and a local computational system. The local memory stores local machine-executable instructions. Execution of the local machine-executable instructions causes the local computational system to repeatedly control the multiple fiber optic temperature sensors to measure the sensor-specific temperature data and to provide the sensor-specific temperature data.

In another aspect, a main magnet configured for generating a main magnetic field is disclosed. The main magnet incorporates a passive shim system. The passive shim system is configured for magnetically shimming the main magnetic field.

In another aspect, a magnetic resonance imaging system incorporating the main magnet and passive shim system is disclosed. The magnetic resonance imaging system comprises a system memory storing system machine-executable instructions and pulse sequence commands. The magnetic resonance imaging system further comprises a system computational system. Execution of the system machine-executable instructions causes the system computational system to acquire k-space data by controlling the magnetic resonance imaging system with the pulse sequence commands. Execution of the system machine-executable instructions further causes the system computational system to repeatedly acquire the sensor-specific temperature data at least during the acquisition of the k-space data during the passive shim system. Execution of the system machine-executable instructions further causes the system computational system to monitor a status of the magnetic resonance imaging system using the repeatedly acquired sensor-specific temperature data.

### BRIEF DESCRIPTION OF THE DRAWINGS

In the following preferred embodiments of the invention will be described, by way of example only, and with reference to the drawings in which:
Fig. 1 illustrates an example of a passive shim system.
Fig. 2 shows a further view of the passive shim system of Fig. 1.
Fig. 3 shows a flow chart which illustrates a method of operating the passive shim system of Figs 1 and 2.
Fig. 4 illustrates an example of a magnetic resonance imaging system.
Fig. 5 shows a flow chart which illustrates a method of operating the magnetic resonance imaging system of Fig. 4.
Fig. 6 illustrates an example of a neural network.
Fig. 7 illustrates the integration of a magnetic resonance imaging system into a cloud based computing system.

### DETAILS DESCRIPTION OF EMBODIMENTS

Like numbered elements in these figures are either equivalent elements or perform the same function. Elements which have been discussed previously will not necessarily be discussed in later figures if the function is equivalent.

A method of using the magnetic resonance imaging system is disclosed. The method comprises acquiring the k-space data by controlling the magnetic resonance imaging system with pulse sequence commands. The method further comprises repeatedly receiving sensor-specific temperature data at least during the acquisition of the k-space data. The sensor-specific temperature data is acquired optically using multiple fiber optic temperature sensors that are thermally coupled to passive shim elements. The method further comprises monitoring a status of the magnetic resonance imaging system using the repeatedly acquired sensor-specific temperature data.

In another example, a computer program is disclosed. The computer program comprises system machine-executable instructions for execution by a system computational system. Execution of the system machine-executable instructions causes the system computational system to perform an example of the method of using the magnetic resonance imaging system.

In an example, there is a passive shim system for a magnetic resonance imaging system. The passive shim system comprises a mounting system for mechanically receiving and positioning multiple passive shim elements. The passive shim system may also comprise the one or more of the multiple passive shim elements. The passive shim system further comprises multiple fiber optic temperature sensors configured for optically measuring sensor-specific temperature data. The multiple fiber optic temperature sensors are thermally coupled to the mounting system and/or the multiple passive shim elements.

In an example the fiber optic temperature sensors work by detecting a change in optical properties of materials that change with temperature. A common method involves coating the tip of an optical fiber with a material whose refractive index or light absorption characteristics vary with temperature. When light is sent through the fiber, it interacts with this material, and changes in the temperature alter the way the light behaves-this could be a shift in wavelength (for example, in fiber Bragg grating sensors), or changes in intensity. The altered light signal travels back through the fiber to a detector, which measures these changes and interprets them as corresponding temperature values. In some examples fiber itself acts as both the sensor and the signal transmission medium. In other examples, a fiber Bragg grating (FBG) sensor may be arranged at the fiber optic cable. The FBG reflects specific wavelengths of light. As the temperature changes, the reflected wavelength changes.

The passive shim system further comprises a controller comprising a local memory and a local computational system. The local memory stores local machine-executable instructions. Execution of the local machine-executable instructions causes the local computational system to repeatedly control the multiple fiber optic temperature sensors to measure the sensor-specific temperature data. Execution of the machine-executable instructions further causes the local computational system to repeatedly provide the sensor-specific temperature data.

This example may be beneficial because it provides a direct measurement of the temperature of the passive shims used for a magnetic resonance imaging system. This may be used to track the change in the magnetic properties of the multiple passive shim elements and thereby predict either a state of the main magnet and/or provide information which can be used to correct magnetic resonance images due to changing field inhomogeneities or to adjust an active shim system dynamically.

Magnetic resonance imaging relies on having a large and uniform magnetic field within an imaging zone. The magnets and other systems magnetic resonance imaging system have imperfections and typically there are some inhomogeneities in the main magnetic field of the main magnet. This may be compensated using a variety of techniques; these include both active and passive shimming. In active shimming there are additional coils where current can be increased or decreased to make adjustments to the magnetic field. In passive shimming passive shim elements are positioned around the bore of the magnet and the magnetic field of the passive shim elements has the effect of modifying the main magnetic field. If the passive shim elements are placed in the correct location, then this may have the effect of making the main magnetic field more uniform within the imaging zone.

A difficulty is that during the course of a long magnetic resonance imaging procedure the passive shims can be heated by the changing electromagnetic field within the bore of the magnetic resonance imaging main magnet. The field inhomogeneity can for example be measured by taking measurements on a phantom. However, this is not practical to do very often because of the large time involved. It also will not be possible to do during the middle of an examination of a subject. Knowing the temperature of the multiple passive shim elements the change in the magnetic properties of the shim can be predicted and this can be used to calculate the change in the magnetic field. This may for example be used to provide a very accurate estimate of how the magnetic field is changing.

Another advantage is that the temperature of these multiple passive shim elements is being measured directly. If there are problems with the gradient coil system or other components this may manifest itself as more energy being deposited into the passive shim elements. By monitoring the temperature of the multiple passive shim elements failures within the magnetic resonance imaging system may be predicted. The sensor-specific temperature data may therefore be used as an early warning system for failures in the magnetic resonance imaging system as well as providing means for improving shimming or the correction of imaging on the fly during a magnetic resonance imaging procedure.

In another example, the mounting system comprises multiple shim pockets configured for receiving one or more of the multiple passive shim elements. The multiple fiber optic temperature sensors are configured such that when one or more of the multiple passive shim elements is placed into one of the multiple shim pockets there is a direct thermal coupling between the one or more of the multiple passive shim elements and one of the multiple fiber optic temperature sensors. In this example, when a passive shim element is placed into one of the multiple shim pockets it is then in thermal contact with one of the multiple fiber optic temperature sensors. This has the advantage that the passive shim elements may have their temperature measured directly. This may provide for a better monitoring of the magnetic resonance imaging system using the sensor-specific temperature data and/or better prediction in the change in the main magnetic field.

In another example, there is a main magnet configured for generating a main magnetic field. As used herein, the term main magnetic field refers to the large magnetic field sometimes referred to as the B0 field of a magnetic resonance imaging system. This is the large magnetic field which is used to align magnetic spins within the imaging zone. In this example, the main magnet incorporates the passive shim examples described above. The passive shim system is configured for magnetically shimming the main magnetic field. As was mentioned above, when the passive shim elements are placed adjacent to the main magnetic field they have an effect on the main field. By placing them in the correct locations the homogeneity of the main magnet field within the imaging zone may be increased.

In another example, there is a magnetic resonance imaging system which incorporates the main magnet and the passive shim system. The magnetic resonance imaging system further comprises a system memory storing machine-executable instructions and pulse sequence commands. The magnetic resonance imaging system further comprises a system computational system. Execution of the system machine-executable instructions causes the system computational system to acquire k-space data by controlling the magnetic resonance imaging system with the pulse sequence commands. Execution of the system machine-executable instructions further causes the system computational system to repeatedly acquire the sensor-specific temperature data at least during the acquisition of the k-space data using the passive shim system.

Execution of the machine-executable instructions further causes the system computational system to monitor a status of the magnetic resonance imaging system using the repeatedly acquired sensor-specific temperature data. As will be described below, the monitoring the status of the magnetic resonance imaging system may have several different examples. This example may be advantageous because the magnetic resonance imaging system now has data or information about the actual warming or change in the temperature of the multiple passive shim elements. As was mentioned before, this may lead to better monitoring and preventative maintenance for a magnetic resonance imaging system and/or improved imaging quality by enabling the adjustment of the active shims on the fly.

In another example, the monitoring of the status of the magnetic resonance imaging system comprises producing a warning signal if the repeatedly acquired sensor-specific temperature data is outside of a predetermined temperature range or has a temperature pattern that deviates from a pulse sequence-specific temperature pattern. In this example, the sensor-specific temperature data itself is monitored and compared to several different criteria to determine if there is a problem with the magnetic resonance imaging system. If the predetermined temperature range is exceeded for individual sensors or sensors as a group an alarm signal may be provided. For particular pulse sequences the combination of the gradient use and the use of the radio-frequency systems, they have the effect of heating the multiple passive shim elements in a predictable way. The pulse sequence-specific temperature pattern describes the temperature change of specific passive shim elements throughout of the course of the pulse sequence. If the temperature of individual passive shim elements differs by more than a certain amount with respect to this pulse sequence-specific temperature pattern, then an alarm can also be used to indicate that there may be a technical problem or fault with the magnetic resonance imaging system.

In another example, execution of the system machine-executable instructions further causes the computational system to perform any one of the following if the warning signal is produced: trigger a visual warning, trigger a text warning on a user interface, cause an audible warning, trigger a service request, cancel the acquisition of the k-space data, restrict execution of the pulse sequence commands, selectively restrict the execution of the individual members of a library of pulse sequence commands, and combinations thereof.

These examples may be beneficial because they may provide for a real time warning if the magnetic resonance imaging system has a fault. In some of the examples, the execution of particular pulse sequence commands is restricted. This may have a benefit because some pulse sequence protocols may have heavier or different gradient use during a magnetic resonance imaging protocol. If the warning signal is detected then the use of particular pulse sequences can be restricted to those that would only cause a problem immediately. This may for example enable the use of a magnetic resonance imaging system when there is a problem with heating of the multiple passive shim elements for only some of the available magnetic resonance imaging protocols. This may for example enable the service of the magnetic resonance imaging system but still enable some protocols to be performed.

In another example, the system memory further stores a magnetic parameter model configured for outputting modification parameters in response to receiving the sensor-specific temperature data as input. The magnetic parameter model as used herein is descriptive of some parameter of the main magnetic field or related control of it. In some examples, the magnetic parameter model may be descriptive of a magnetic field map of the main magnetic field. In other examples, they may for example be settings for controlling the active shim coil system. Execution of the system machine-executable instructions further causes the system computational system to receive starting magnetic parameters descriptive of a starting field map of the main magnetic field. This may actually be indirectly descriptive of the starting field map. For example, the starting magnetic parameters may be the starting settings of the active shim coils. In other examples the starting magnetic parameters may actually be a starting magnetic field map of the main magnetic field.

Execution of the system machine-executable instructions further causes the system computational system to receive the modification parameters in response to inputting the sensor-specific temperature data into the magnet parameter model. Execution of the system machine-executable instructions further causes the system computational system to provide updated parameters using the starting parameters and the modification parameters. This example encompasses both calculating an updated main magnetic field as well as directly determining modification parameters for changing the active shim of the magnetic resonance imaging system.

In another example, execution of the system machine-executable instructions further causes the computational system to generate a magnet alarm signal if the updated parameters are outside of a predetermined parameter range. For example, if the modification parameters are used to control the active shims of the magnetic resonance imaging system, if the shims are moved outside of this predetermined range this may trigger an alarm which could be used to either alert the operator of the system or to contact service personnel automatically.

In another example, the magnetic resonance imaging system comprises an active magnetic field shimming system. Execution of the system machine-executable instructions further causes the system computational system to adjust the active magnetic field shimming system using the updated parameters or the modification parameters. This example is beneficial because it may be used to change the values or controls of the active magnetic field shimming system automatically. In some cases this may be performed as the magnetic resonance imaging protocol is being performed using the pulse sequence commands. This may represent a huge benefit to account for the heating of the passive shims during the actual execution of pulse sequence commands.

In another example, execution of the system machine-executable instructions further causes the computational system to repeatedly provide the updated parameters during execution of the pulse sequence commands and/or before execution of subsequent pulse sequence commands. Execution of the system machine-executable instructions further causes the computational system to perform further adjustment of the active magnetic field shimming system after the updated parameters or the modification parameters are provided. This may provide for a means of automatically shimming the main magnet during the execution of pulse sequence commands or between subsequent groups of pulse sequence commands.

In another example, the starting parameters are starting a magnetic field map. The modification parameters are a modification of the main magnetic field. The updated parameters are an updated magnetic field map. The magnetic parameter model is a magnetic field model. Having a knowledge of how the magnetic field changes may be useful not only for adjusting the shims, but may also be used during the reconstruction as the local magnetic field may be known. This may provide for improved quality in magnetic resonance images. The starting magnetic field map may for example be measured by placing a phantom in the magnetic resonance imaging system and then looking for phase changes. The measurement of B0 inhomogeneity may be performed by a process known as B0 mapping. This typically involves taking images at multiple echo times (TE) to measure phase differences. The phase changes and be equated with absolute B0 measurements or a map of the B0 inhomogeneity.

The magnetic parameter model to calculate a change in the magnetic field may be calculated in a straightforward way analytically. The location of the passive shims are known and the size and magnetic properties of the shims are also known. As the temperature changes the magnetic field generated by an individual shim is changed. This change can be calculated for each shim individually and then superimposed to calculate the change in the magnetic field. As a first approximation, the individual shims may be treated as a dipole. However, more complicated models, such as a finite difference model, may be used to take into account the actual shape of a shim.

In another example, the starting parameters are starting magnetic shim settings. The modification parameters are changes in the magnetic shim settings, and the updated parameters are updated magnetic shim settings. In this example, instead of for example calculating the field and then indirectly calculating the modified shim settings, the model directly provides the changes in the magnetic shims.

In another example, the magnetic parameter model is any one of the following: a neural network, an analytical model, and a random forest regressor. As was mentioned above, the analytical model may be implemented by calculating the effect on the magnetic field by the individual passive shims. The neural network may be trained for either calculating the effect on the magnetic field map or for adjusting the magnetic shim settings. The neural network may for example be implemented in several different ways. There is a spatial mapping of the temperature that is measured with the fiber optic temperature sensors. The neural network may therefore comprise several convolutional layers. In addition to, or as an alternative, the neural network may be formed using several fully connected layers.

The neural network may be trained by providing training data which has pairs of input and output (ground truth) data. The input data could be the various temperature measurements and as an output would be the modification parameters. A training method such as deep learning could then be used.

In another example, the magnetic parameter model is a random forest regressor. The starting magnetic field map of the main magnetic field is descriptive of the main magnetic field without a subject. The random forest regressor is configured to predict changes in the main magnetic field using subject metadata. Execution of the system machine-executable instructions further causes the system computational system to receive subject metadata. The modification of the main magnetic field is received in response to inputting the sensor-specific temperature data and the subject metadata into the magnetic parameter model. This example may be beneficial because it provides changes in the magnetic field not just due to the temperature data, but also a description of the subject.

A Random Forest Regressor is able to predicting continuous values. It generates an ensemble of decision trees, each trained on a random subset of the training data and a random subset of features. For each tree, the training data is sampled with replacement (bootstrap sampling), and the tree is built by splitting on features that minimize the error (usually mean squared error). After training, the Random Forest Regressor makes predictions by averaging the outputs from all the individual trees, reducing variance and improving the accuracy and robustness of the model compared to individual decision trees. An advantage of using the Random Forest Regressor is that details about the subject such as weight, age, health problems, and etc. may be integrated into the trained Random Forest Regressor along with the training data used to train the neural network.

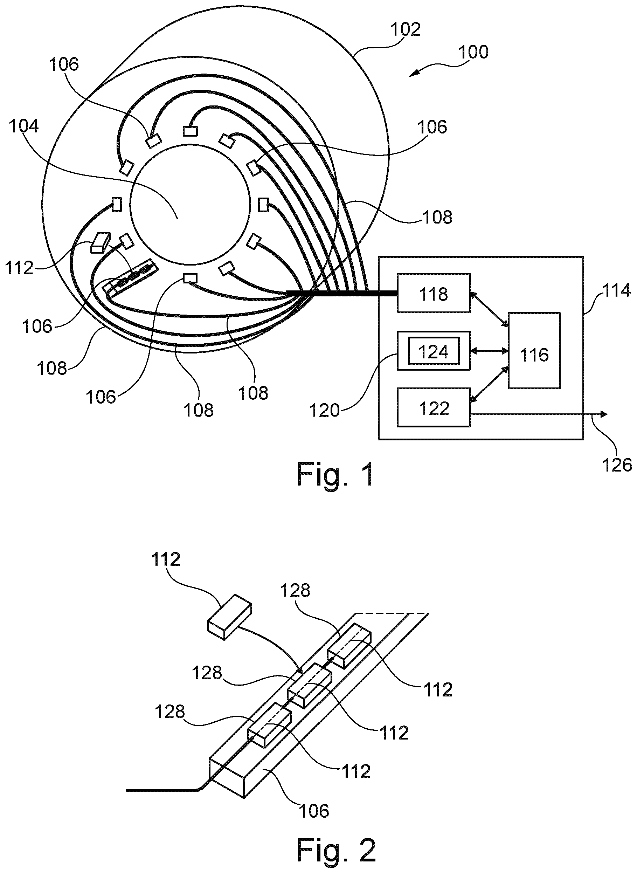

Fig. 1 illustrates an example of a passive shim system 100 installed on a main magnet 102. The main magnet 102 in this example is a cylindrical type magnet 102 and has a bore 104 through the center of it. Around the bore of the magnet 104 is an array of mounting systems 106. In this example, they are trays which may be slid into slots in the magnet 102. The mounting system 106 or tray has pockets 128 for receiving the passive shim elements 112. The passive shim system 100 further comprises fiber optic cables 108 that are attached to fiber optic temperature sensors 112 that are in thermal contact with the passive shim elements 112. The passive shim system 100 further comprises a controller 114. The controller 114 comprises a local computational system 116. The local computational system 116 is in communication with an optical interface 118, a memory 120, and a hardware interface 122. The optical interface 118 is configured for interfacing optically with the fiber optic cables 108 and reading the temperature from the fiber optic temperature sensors 110.

The memory 120 is any type of memory or storage which may be accessible to the local computational system 116. The hardware interface 122 enables the local computational system 116 to communicate with other devices. In this example it has an output 126 for providing the sensor-specific temperature data 126. The memory 120 stores local machine-executable instructions 124 which enable the local computational system 116 to control the various components of the controller 114 and to generate the sensor-specific temperature data 126 from measurements made using the optical interface 118.

Fig. 2 shows a close up view of the mounting system 106, which in this case is a tray. The mounting system 106 has pockets 128 configured to receive one or more of the passive shim elements 112. Normally in use, the passive shim elements 112 would be placed selectively in different pockets in order to shim the main magnet field. There may then be a fiber optic temperature sensor 110 available for each of the pockets 128 in some examples. If one or more passive shim elements 112 are placed into a pocket 128 then they may come in contact with the fiber optic temperature sensor 110 positioned there.

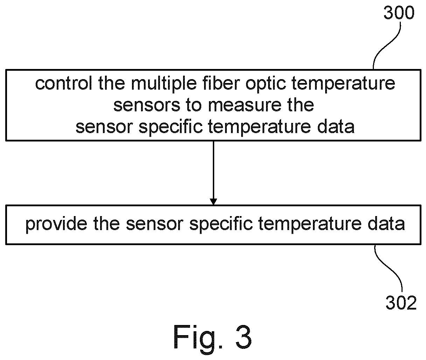

Fig. 3 shows a flowchart which illustrates a method of using the passive shim system 100 illustrated in Figs. 1 and 2. In step 300, the execution of the local machine-executable instructions 124 causes the local computational system 300 to repeatedly control the fiber optic temperature sensors 110 to measure the sensor-specific temperature data 126. In step 302, the sensor-specific temperature data 126 is provided. For example, it may be provided for a control system of a magnetic resonance imaging system or other computer system. For example, if the controller for the magnetic resonance imaging system is not monitoring or storing the sensor-specific temperature data 126 it may be logged by another machine which monitors the magnetic resonance imaging system to determine when maintenance should be performed.

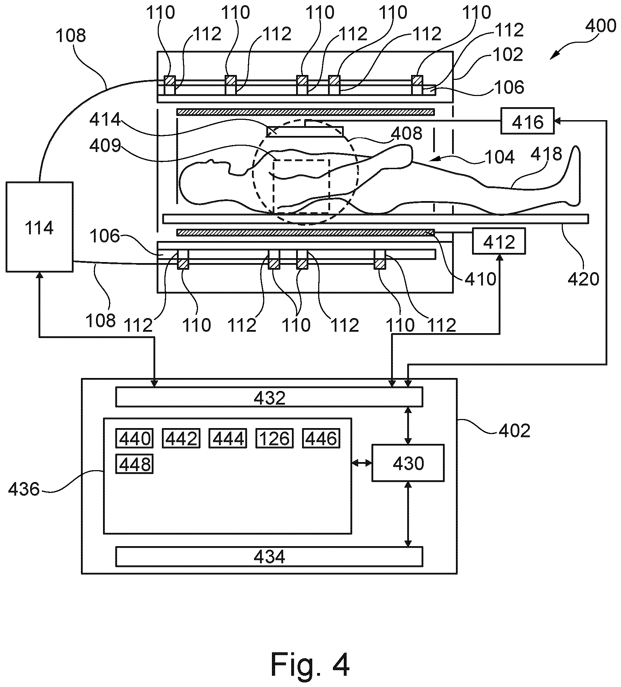

Fig. 4 illustrates an example of a magnetic resonance imaging system 400 that incorporates the passive shim system 100 and the main magnet 102 illustrated in Figs. 1 and 2. Fig 4 illustrates the relationship between various components of the magnetic resonance imaging system 400 but is not to scale and does not depict realistic mechanical arrangements, in particular the mounting system 106 and the fiber optic cables 108 are shown as being pasted into the main magnet 102. The mechanical arrangement here is intended to show its relationship to the bore 104 of the magnet 102 but is not mechanically accurate.

The magnetic resonance imaging system 400 comprises a magnet 102. The magnet 102 is a superconducting cylindrical type magnet with a bore 104 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 104 of the cylindrical magnet 102 there is an imaging zone 408 where the magnetic field is strong and uniform enough to perform magnetic resonance imaging. A field of view 409 is shown within the imaging zone 408. The k-space data are acquired for the field of view 409. The region of interest could be identical with the field of view 409 or it could be a sub volume of the field of view 409. A subject 418 is shown as being supported by a subject support 420 such that at least a portion of the subject 418 is within the imaging zone 408 and the field of view 409.

Element 410 represents the magnetic field gradient coils and the active shim system. Box 412 represents the magnetic field gradient coil power supply 412 and also the power supply or control for the active shimming system. Adjacent to the active shims 410 is the mounting system 106. Various passive shim elements 112 have been inserted into some pockets and then are in contact with fiber optic temperature sensors 110 that use the fiber optic cables 108 to communicate with the controller 114.

Adjacent to the imaging zone 408 is a radio frequency coil 414 for manipulating the orientations of magnetic spins within the imaging zone 408 and for receiving radio transmissions from spins also within the imaging zone 408. The radio frequency antenna may contain multiple coil elements. The radio frequency antenna may also be referred to as a channel or antenna. The radio frequency coil 414 is connected to a radio frequency transceiver 416. The radio frequency coil 414 and radio frequency transceiver 416 may be replaced by separate transmit and receive coils and a separate transmitter and receiver. It is understood that the radio frequency coil 414 and the radio frequency transceiver 316 are representative. The radio frequency coil 414 is intended to also represent a dedicated transmit antenna and a dedicated receive antenna. Likewise, the transceiver 416 may also represent a separate transmitter and receiver. The radio frequency coil 414 may also have multiple receive/transmit elements and the radio frequency transceiver 416 may have multiple receive/transmit channels. The transceiver 416 and the gradient controller 412 are shown as being connected to hardware interface 432 of a computer system 402.

The magnetic resonance imaging system further comprises a computer 402, which functions as a local controller for the magnetic resonance imaging system 400. The computer 402 is intended to represent one or more computers located at one or more locations. The computer 402 comprises a system computational system 430. The system computational system 430 is intended to represent one or more computational systems or computing cores located at one or more locations. The system computational system 430 is in communication with a hardware interface 432, an optional user interface 434, and a memory 436. The local hardware interface 432 is connected to the controller 114, the power supply for the magnetic field gradient coil power supply and active shims 412 as well as the transceiver 416. The system computational system 430 is able to control the various components of the magnetic resonance imaging system using the hardware interface 432. The optional user interface 434 may provide a means for a local operator to control and monitor the functioning of the magnetic resonance imaging system 400. The memory 436 is intended to represent various types of memory which are accessible to the system computational system 430.

The system memory 436 is shown as containing system machine-executable instructions 440. The system machine-executable instructions 440 enable the system computational system 430 to control and operate the magnetic resonance imaging system 400 as well as perform various data analysis, data manipulation, and image processing tasks, for example, reconstructing magnetic resonance images. The memory 436 is further shown as containing pulse sequence commands 442. This is commands or data which may be converted into commands to directly control the magnetic resonance imaging system to acquire k-space data 444. The memory 436 is shown as storing k-space data 444 that was acquired by controlling the magnetic resonance imaging system with the pulse sequence commands 442.

The memory 436 is further shown as containing the sensor-specific temperature data 126. This was acquired at least during the acquisition of the k-space data 444. There may be additional sensor-specific temperature data 126 that is acquired before and after the acquisition of the k-space data 444 also. For example, the temperature before and also the amount of time needed to cool down may also be monitored.

The memory 436 is shown as containing an optional magnetic parameter model 446 that may take the sensor-specific temperature data 126 as input and then output modification parameters 448. For example, the modification parameters 448 may be changes in the magnetic field within the imaging zone 408 as well as commands for how to adjust the active shims to compensate for changes in the magnetic field due to temperature changes in the passive shim elements 112.

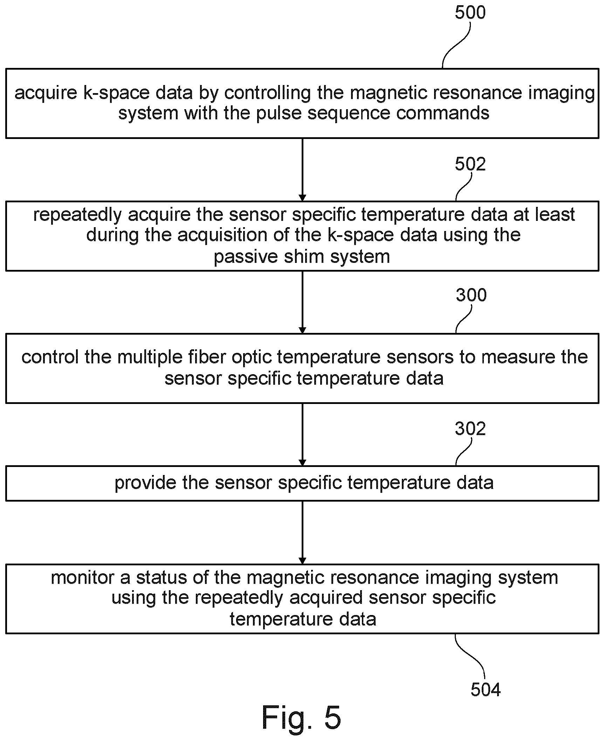

Fig. 5 shows a flowchart which illustrates a method of operating the magnetic resonance imaging system 400 illustrated in Fig. 4. In step 500, the k-space data 444 is acquired by controlling the magnetic resonance imaging system 400 with the pulse sequence commands 442. While this is occurring, step 500 is also performed. In step 500, the sensor-specific temperature data 126 is repeatedly acquired at least during the acquisition of the k-space data 444 using the passive shim system 100. Steps 300 and 302 are performed as they were illustrated in Fig. 3. In step 504, a status of the magnetic resonance imaging system is monitored using the repeatedly acquired sensor-specific temperature data 126. This may entail monitoring the values directly or it may mean inputting them into the magnetic parameter model 446 and monitoring the modification parameters 448.

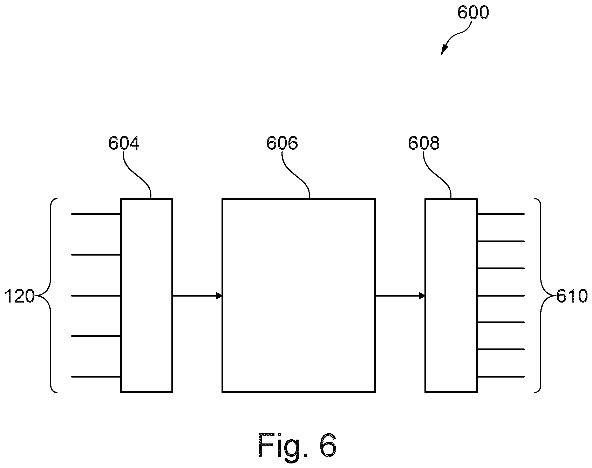

Fig. 6 illustrates an example of a neural network that may be used to provide one implementation of the magnetic parameter model 446. The neural network 600 comprises an input layer 604, several hidden layers 606, and an output layer 608. The sensor-specific temperature data 126 is input into the input layer 604. The input layer may have a size equal to the number of temperature sensors that are input into the neural network. In some instances it may also be equal to the number of passive shims or the number of pockets for receiving passive shims. For example, an optimal way of implementing this would be to have one input for each temperature sensor available on the system. The hidden layers 608 may for example contain two or three convolutional layers and/or two or three fully connected layers. The hidden layers are then connected to the output 608. The output layer 608 may for example have a number of layers equal to the number of adjustments possible for the active shims. The modification parameters 610 may be output directly from the output layers 608.

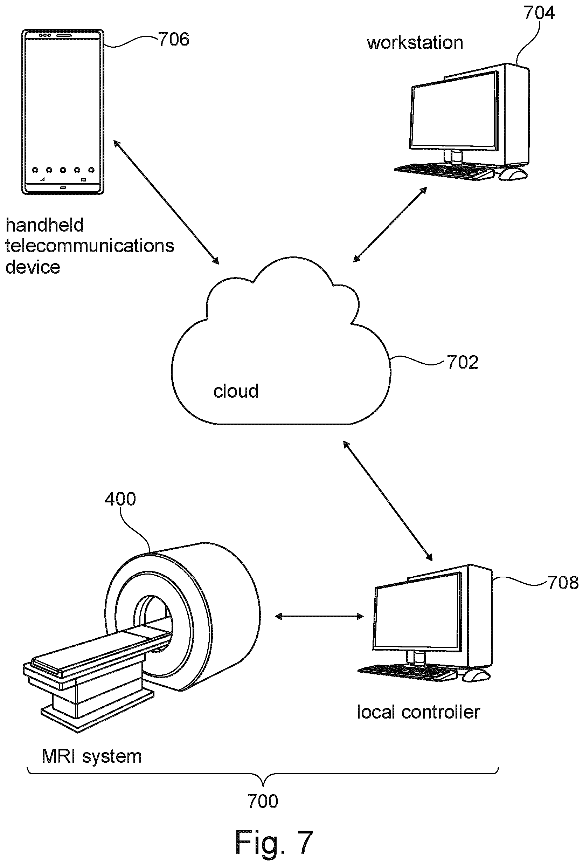

Fig. 7 illustrates an example of a medical system 700. The medical system 700 comprises the magnetic resonance imaging system 400 as well as a cloud based computing system 702, a radiology workstation 704, a handheld telecommunications device 706, and a local controller 708. The functionality of the computer 402 in Fig. 4 may be distributed amongst the various devices 702, 704, 706, and 708. The cloud based computing system 702 could be made up of networked servers and/or virtual machines available over the internet or other network.

A typical configuration would be to use the local controller 708 to use the pulse sequence commands 442 to control the magnetic resonance imaging system 400 to acquire the k-space data 444. The reconstruction of magnetic resonance images from the k-space data 444 may be performed by the cloud based computing system 702. The resulting magnetic resonance image would then be made available to the workstation 704, the handheld telecommunications device 706, and the local controller 708.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: passive shim system
- 102: main magnet
- 104: bore of magnet
- 106: mounting system (tray)
- 108: fiber optic cable
- 110: fiber optic temperature sensors
- 112: passive shim element
- 114: controller
- 116: local computational system
- 118: optical interface
- 120: local memory
- 122: hardware interface
- 124: local machine executable instructions
- 126: output for sensor specific temperature data
- 128: pocket
- 300: control the multiple fiber optic temperature sensors to measure the sensor specific temperature data
- 302: provide the sensor specific temperature data
- 400: magnetic resonance imaging system
- 402: computer
- 408: imaging zone
- 409: field of view
- 410: magnetic field gradient coils / active shims
- 412: magnetic field gradient coil power supply / power supply for active shims
- 414: radio frequency coil
- 416: transceiver
- 418: subject
- 420: subject support
- 430: system computational system
- 432: hardware interface
- 434: optional user interface
- 436: system memory
- 440: system machine executable instructions
- 442: pulse sequence commands
- 444: k-space data
- 446: magnetic parameter model
- 448: modification parameters
- 500: acquire k-space data by controlling the magnetic resonance imaging system with the pulse sequence commands
- 502: repeatedly acquire the sensor specific temperature data at least during the acquisition of the k-space data using the passive shim system
- 504: monitor a status of the magnetic resonance imaging system using the repeatedly acquired sensor specific temperature data
- 600: neural network
- 602: sensor specific temperature data
- 604: input layer
- 606: hidden layers
- 608: output layers
- 610: modification parameters
- 700: medical system
- 702: cloud computing system
- 704: workstation
- 706: handheld telecommunications device
- 708: local controller

## Claims

1. A passive shim system (100) for a magnetic resonance imaging system (400), comprising:
- a mounting system (106) for mechanically receiving and positioning multiple passive shim elements (112);
- multiple fiber optic temperature sensors (110) configured for optically measuring sensor specific temperature data (126), wherein the multiple fiber optic temperature sensors are thermally coupled to the mounting system and/or the multiple passive shim elements; and
- a controller (114) comprising a local memory (120) and a local computational system (116), wherein the local memory stores local machine executable instructions (124), wherein execution of the local machine executable instructions causes the local computational system to repeatedly:
- control (300) the multiple fiber optic temperature sensors to measure the sensor specific temperature data, and
- provide (302) the sensor specific temperature data.

2. The passive shim system of claim 1, wherein the mounting system comprises multiple shim pockets (128) configured for receiving one or more of the multiple passive shim elements, wherein the multiple fiber optic temperature sensors are configured such that when the one or more of the multiple passive shim elements is placed into one of the multiple shim pockets there is a direct thermal coupling between the one or more of the multiple passive shim elements and one of the multiple fiber optic temperature sensors.

3. A main magnet (102) configured for generating a main magnetic field, wherein the main magnet incorporates the passive shim system of claim 1 or 2, wherein the passive shim system is configured for magnetically shimming the main magnetic field.

4. A magnetic resonance imaging system (400) incorporating the main magnet (102) of claim 3, wherein the magnetic resonance imaging system comprises:
- a system memory (436) storing system machine executable instructions (440) and pulse sequence commands (442);
- a system computational system (430), wherein execution of the system machine executable instructions causes the system computational system to:
- acquire (500) k-space data (444) by controlling the magnetic resonance imaging system with the pulse sequence commands;
- repeatedly (502) acquire the sensor specific temperature data at least during the acquisition of the k-space data using the passive shim system; and
- monitor (504) a status of the magnetic resonance imaging system using the repeatedly acquired sensor specific temperature data.

5. The magnetic resonance imaging system of claim 4, wherein monitoring the status of the magnetic resonance imaging system comprises producing a warning signal if the repeatedly acquired sensor specific temperature data is outside of a predetermined temperature range or has a temperature pattern that deviates from a pulse sequence specific temperature pattern.

6. The magnetic resonance imaging system of claim 5, wherein execution of the system machine executable instructions further causes the system computational system to perform any one of the following if the warning signal is produced: trigger a visual warning, trigger a text warning on a user interface, cause an audible warning, trigger a service request, cancel the acquisition of the k-space data, restrict the execution of pulse sequence commands, selectively restrict the execution of individual members of a library of pulse sequence commands, and combinations thereof.

7. The magnetic resonance imaging system of any one of claims 4, 5, or 6, wherein the system memory further stores a magnetic parameter model (446) configured for outputting modification parameters in response to receiving the sensor specific temperature data as input, wherein execution of the system machine executable instructions further causes the system computational system to:
- receive starting magnetic parameters descriptive of a starting field map of the main magnetic field;
- receive the modification parameters in response to inputting the sensor specific temperature data into the magnetic parameter model; and
- provide updated parameters using the starting parameters and the modification parameters.

8. The magnetic resonance imaging system of claim 7, wherein execution of the system machine executable instructions further causes the computational system to generate a magnet alarm signal if the updated parameters are outside of a predetermined parameter range.

9. The magnetic resonance imaging system of claim 7 or 8, wherein the magnetic resonance imaging system comprises an active magnetic field shimming system (410), wherein execution of the system machine executable instructions further causes the system computational system to adjust the active magnetic field shimming system using the updated parameters or the modification parameters.

10. The magnetic resonance imaging system of claim 9, wherein execution of the system machine executable instructions further causes the system computational system to:
- repeatedly provide the updated parameters during the execution during execution of the pulse sequence commands and/or before execution of subsequent pulse sequence commands; and
- perform further adjustment of the active magnetic field shimming system after the updated parameters or the modification parameters are provided.

11. The magnetic resonance imaging system of any one of claims 7 through 10, wherein any one of the following:
- the starting parameters are starting magnetic field map, the modification parameters are a modification of the main magnetic field, and the updated parameters are updated magnetic field map, the magnetic parameter model is a magnetic field model; and
- the starting parameters are starting magnetic shim settings, the modification parameters are changes in the magnetic shim settings, and the updated parameters are updated magnetic shim settings.

12. The magnetic resonance imaging system of any one of claims 7 through 11, wherein the magnetic parameter model is any one of the following: a neural network, an analytical model, and a random forest regressor.

13. The magnetic resonance imaging system of claim 12, wherein the magnetic parameter model is a random forest regressor, wherein the starting magnetic field map of the main magnetic field is descriptive of the main magnetic field without a subject, wherein the random forest regressor is configured to predict changes in the main magnetic field using subject metadata, wherein execution of the system machine executable instructions further causes the system computational system to receive the subject metadata, wherein the modification of the main magnetic field is received in response to inputting the sensor specific temperature data and the subject metadata into the magnetic parameter model.

14. A method of using magnetic resonance imaging system (400), wherein the method comprises:
- acquiring (500) k-space data (444) by controlling the magnetic resonance imaging system with pulse sequence commands (442);
- repeatedly acquire (502) sensor specific temperature data (126) at least during the acquisition of the k-space data, wherein the sensor specific temperature data is acquired optically using multiple fiber optic temperature sensors (110) that are thermally coupled to passive shim elements (100); and
- monitoring (504) a status of the magnetic resonance imaging system using the repeatedly acquired sensor specific temperature data.

15. A computer program comprising system machine executable instructions (440) for execution by a system computational system (430), wherein execution of the system machine executable instructions causes the system computational system to perform the method according to claim 14.
